## Europäisches Patentamt

## European Patent Office

## Office européen des brevets

(19)

(11) Veröffentlichungsnummer: **0 026 900**
**A1**

(12) ## EUROPÄISCHE PATENTANMELDUNG

(21) Anmeldenummer: **80105888.4**

(22) Anmeldetag: **29.09.80**

(51) Int. Cl.³: **G 03 D 5/06**

(30) Priorität: **06.10.79 DE 2940579**

(43) Veröffentlichungstag der Anmeldung: **15.04.81**
**Patentblatt 81/15**

(84) Benannte Vertragsstaaten: **DE FR GB IT**

(71) Anmelder: **HOECHST AKTIENGESELLSCHAFT, KALLE Niederlassung der Hoechst AG Patentabteilung Postfach 3540, Rheingaustrasse 190 D-6200 Wiesbaden 1 (DE)**

(72) Erfinder: **Helst, Hans, Frankenwaldstrasse 7, D-6200 Wiesbaden-Delkenheim (DE)**

(54) **Antragsvorrichtung für lackentwickelbare Druckplatten.**

(57) Eine Antragsvorrichtung (10) für lackentwickelbare Druckplatten umfaßt einen Vorratsbehälter (1), der mit Lack (3) gefüllt ist und über einen Befestigungswinkel (12) mit einer Oszillatoreinrichtung (15) verbunden ist. Am Befestigungswinkel (12) ist über einen Plüschträger (14) und einen Winkel (20) ein Ausreibeplüsch (13) angebracht, der durch die Oszillatoreinrichtung (15) ebenso wie die Antragsvorrichtung (10) quer zur Durchlaufrichtung einer Druckplatte (16) hin und her bewegt wird, wie dies der Doppelpfeil B–B andeutet.

Der Vorratsbehälter (1) weist im Behälterboden (4) eine Anzahl von Antragsöffnungen (5) für den Lack auf, die mit Durchlässen (17) von darüberliegenden Führungen (7) in Verbindung stehen. Die im Lack zur Gänze eingetauchten Führungen (7) enthalten Ventilkugeln (6), die mit seitlichem Spiel (9,9') in den Führungen gelagert sind. Im Stillstand der Antragsvorrichtung (10) verschließen die Ventilkugeln (6) die Antragsöffnungen. Während der oszillierenden Bewegung der Antragsvorrichtung (10) führen die Ventilkugeln (6) in den Führungen eine durch das Lagerspiel begrenzte Schaukelbewegung aus und geben dadurch jeweils für eine bestimmte Zeitspanne die Durchlässe (17) frei, so daß Lack an die Druckplatte (16) angetragen wird.

0026900

HOECHST AKTIENGESELLSCHAFT
KALLE Niederlassung der Hoechst AG

Hoe 79/K 038          - 1 -     26. September 1980
                                WLK-DI.Z.-is


Antragsvorrichtung für lackentwickelbare Druckplatten


Die Erfindung betrifft eine Antragsvorrichtung für lackentwickelbare Druckplatten, mit einem Ausreibeplüsch, der mit einer Oszillatoreinrichtung verbunden ist.

Es ist bekannt, daß Offsetdruckplatten für die Negativ-Kopie durch die Einwirkung von Licht im nahen Ultravio - lett-Bereich in der Photopolymer-Schicht der Platte an den im Negativ transparenten Stellen gehärtet werden. Die nicht gehärteten Stellen werden anschließend durch einen Entwickler gelöst. In ähnlicher Weise erfolgt auch die Entwicklung von Offsetdruckplatten für Positiv-Kopien. Bei bekannten Verarbeitungsanlagen für Offset-Druckplatten werden beispielsweise vier Arbeitsgänge, nämlich das Entwickeln, Fixieren, Spülen und Trocknen der Platte automatisch in einem Durchgang ausgeführt. Im Anschluß daran werden dann die Platten häufig auch noch in einer eigenen Lackiervorrichtung mit einem Lack versehen, um den Bildaufbau zu verstärken und damit die Druckauflage zu erhöhen.

Die US-PS 3 955 433 betrifft eine automatische Entwicklungsvorrichtung für Offsetplatten, in der die belichtete Platte durch den Kontakt der belichteten Oberfläche der Platte mit einer herkömmlichen Entwicklerflüssigkeit entwickelt wird. Hierbei wird die Oberfläche einer linearen, hin- und hergehenden Reibwirkung eines Schwamms ausgesetzt. Hierzu treibt ein einzelner Elektromotor jede Rolle von zwei Bahnen von miteinander

HOECHST AKTIENGESELLSCHAFT
KALLE Niederlassung der Hoechst AG

- 2 -

gekoppelten Antriebsrollen an, um den Schwamm in Reibkontakt mit einer im wesentlichen horizontalen Offset-
Druckplatte während der Hin- und Herbewegung des
Schwammes zu halten. Analog hierzu aufgebaute Einheiten, d.h. ähnlich wie die Entwicklungsvorrichtung ermöglichen es, die Platte anschließend zu waschen und zu
gummieren.

Zum Stand der Technik nach der US-PS 3 983 758 gehört
ferner eine Einrichtung zur Befestigung eines Schwammes
in einer automatischen Entwicklungsmaschine für Offset-
Druckplatten. Der Schwamm ist quer zur Transportrichtung der Druckplatte auf dieser hin- und herbewegbar.
Auf der Eingabeseite der Druckplatte der Entwicklungsmaschine verreibt der Schwamm Entwicklerlösung auf
der Druckplatte. Auf der Ausgangsseite verreibt der
Schwamm Waschwasser auf der Druckplatte. Bei der aus
der DE-OS 26 14 624 bekannten Vorrichtung zum Entwickeln der nicht-polymerisierten Bestandteile einer
Photopolymeren-Druckplatte erfolgt eine oszillierende
Bewegung einer Bürste bzw. eines Plüschs über die Oberfläche der Platte.

Den bekannten Vorrichtungen ist gemeinsam, daß sie beispielsweise nur die Entwicklung einer Druckplatte
durchführen, nicht jedoch diese zugleich in einem Arbeitsgang lackieren. Es ist offensichtlich, daß mehrere
Arbeitsgänge mit Hilfe von mehreren Maschinen durchgeführt werden müssen, bevor die Druckplatte im druckfähigen Endzustand ist, wodurch der Zeitaufwand für die

HOECHST AKTIENGESELLSCHAFT
KALLE Niederlassung der Hoechst AG

- 3 -

Herstellung der Druckplatte relativ groß wird, was insbesondere bei dem Einsatz von Offset-Druckplatten im Zeitungsdruck wegen der gewünschten Aktualität der zu druckenden Nachrichten nicht vertretbar ist.

Aufgabe der Erfindung ist es, eine Antragsvorrichtung zur schnelleren Verarbeitung einer Druckplatte zu schaffen, mit der in einem Arbeitsgang die Druckplatte gleichzeitig entwickelt und lackiert wird.

Diese Aufgabe wird erfindungsgemäß dadurch gelöst, daß an der Oszillatoreinrichtung ein Vorratsbehälter für Lack befestigt ist, der im Behälterboden eine Anzahl von Antragsöffnungen aufweist, die mit darüberliegenden Durchlässen von Führungen in Verbindung stehen und daß in den Führungen Ventilkugeln angeordnet sind, die die Durchlässe öffnen und schließen.

In Ausbildung der Erfindung ist der Vorratsbehälter in Durchlaufrichtung A von der Druckplatte gesehen vor dem Ausreibeplüsch an einem Befestigungswinkel der Oszillatoreinrichtung angebracht. Dabei ist über jeder Antragsöffnung eine Führung mit einer Ventilkugel vorhanden, und es ist jede Ventilkugel mit seitlichem Spiel in der Führung gelagert. Die weitere Ausgestaltung der Erfindung ergibt sich aus den Merkmalen der Ansprüche 4 bis 8.

Mit der Erfindung wird der Vorteil erzielt, daß durch den dosierten Antrag eines Lackentwicklers mit an-

0026900

schließendem oszillierendem Aus- bzw. Einreibesystem in einem Durchlauf der Druckplatte zwei Arbeitsgänge durchgeführt werden, wodurch es zu einer erheblichen Zeiteinsparung kommt, die vor allem in Zeitungsbetrieben angestrebt wird.

Die Erfindung wird im folgenden anhand eines zeichnerisch dargestellten Ausführungsbeispiels näher erläutert.

Es zeigen:

Fig. 1 eine schematische Schnittansicht der Antragsvorrichtung mit Vorratsbehälter für den Lack und einem Ausreibeplüsch und

Fig. 2 eine schematische Vorderansicht des Vorratsbehälters in Richtung A in Fig. 1.

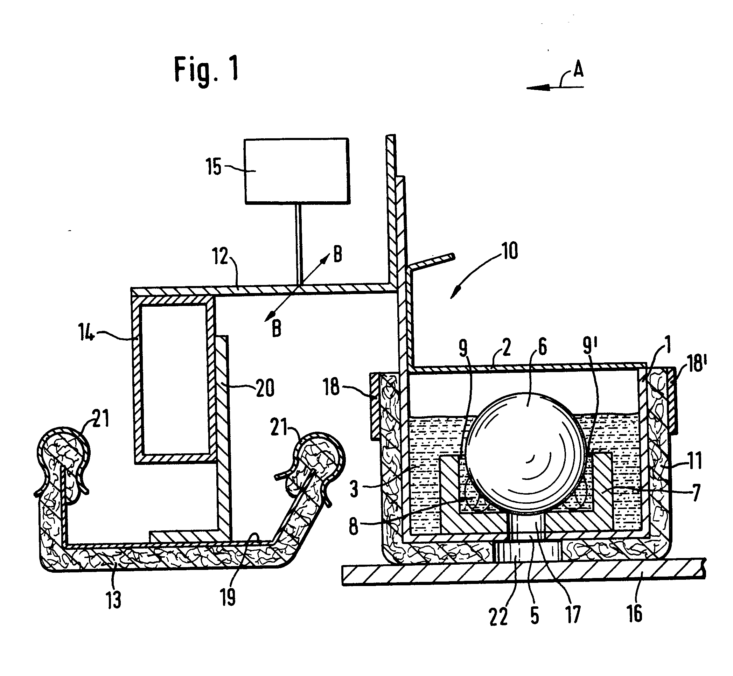

Eine Antragsvorrichtung 10 umfaßt einen Vorratsbehälter 1, der mit einem Lack 3 bis auf eine bestimmte Höhe gefüllt ist. Der Vorratsbehälter 1 steht über einen Befestigungswinkel 12 mit einer Oszillatoreinrichtung 15 in Verbindung, die in Fig. 1 schematisch angedeutet ist. Da es sich bei dieser Oszillatoreinrichtung um eine bekannte Vorrichtung handelt, wird diese weder näher dargestellt noch erläutert. Die Oszillatoreinrichtung 15 bewegt den Befestigungswinkel 12 und damit die Antragsvorrichtung 10 und den Ausreibeplüsch 13 hin und her, wie dieser durch den Doppelpfeil B-B in Fig. 1

HOECHST AKTIENGESELLSCHAFT
KALLE Niederlassung der Hoechst AG

- 5 -

angedeutet ist. Diese Bewegung verläuft quer, d.h. senkrecht zu der Durchlaufrichtung A einer Druckplatte 16, die in Kontakt mit der Außenfläche eines Behälterbodens 4 des Vorratsbehälters 1 bewegt wird.

Der Vorratsbehälter 1 besitzt im Behälterboden 4 eine Anzahl von Antragsöffnungen 5, z.B. Bohrungen, die mit Durchlässen 17 von darüberliegenden Führungen 7 in Verbindung stehen.

Die Führungen 7 tauchen zur Gänze im Lack ein und enthalten Ventilkugeln 6, die mit seitlichem Spiel 9,9' in der jeweiligen Führung 7 gelagert sind. Im Stillstand der Antragsvorrichtung 10, d.h. wenn die Oszillatoreinrichtung 15 stillgesetzt ist, verschließen die Ventilkugeln 6 die Durchlässe 17 und somit die Antragsöffnungen 5.

Der Vorratsbehälter 1 ist in Durchlaufrichtung A der Druckplatte gesehen vor dem Ausreibeplüsch an dem Befestigungswinkel 12 der Oszillatoreinrichtung 15 angebracht. Ein Deckel 2 verschließt den Vorratsbehälter 1 und verhindert, daß während der Oszillatorbewegung der Antragsvorrichtung 10 Lack aus dem Vorratsbehälter überschwappen kann.

Die Führungen 7 weisen einen U-förmigen Querschnitt auf und es ist zumindest eine Öffnung 8, beispielsweise eine Bohrung oder ein Schlitz vorhanden, durch die der Lack 3 aus dem Lackvorrat im Vorratsbehälter 1 in die Führung 7 eintreten kann. Im allgemeinen sind zwei Öffnungen 8 vorgesehen, die symmetrisch zu der Mittellinie durch den Durchlaß 17 liegen.

Der Ausreibeplüsch 13 ist über einen Winkel 20 und einen Plüschträger 14 an dem horizontalen Schenkel des Befestigungswinkels 12 angebracht. Der Plüschträger 14 kann beispielsweise ein Rechteckrohr sein. An dem Winkel 20 ist ein Trägerblech 19 befestigt, an dessen Außenseite der Ausreibeplüsch 13 anliegt, der an den oberen Abschlußkanten des Trägerblechs 19 durch Klammern 21 gehalten wird. Diese Befestigungsart ermöglicht ein rasches Auswechseln des Ausreibeplüsches 13, indem nur die Klammern 21 abgezogen werden, so daß der Ausreibeplüsch 13 von dem Trägerblech 19 abgenommen werden und durch einen neuen Ausreibeplüsch ersetzt werden kann.

An den Außenseiten des Vorratsbehälters 1 ist ein weiterer Ausreibeplüsch 11 angebracht, der mit der Lackschicht auf der Druckplatten-Oberfläche zuerst in Berührung kommt. Der Plüsch 11 weist eine Austrittsöffnung 22 mit einem größeren Durchmesser als derjenige der Antragsöffnung 5 auf, die koaxial an die Austrittsöffnung 22 anschließt.

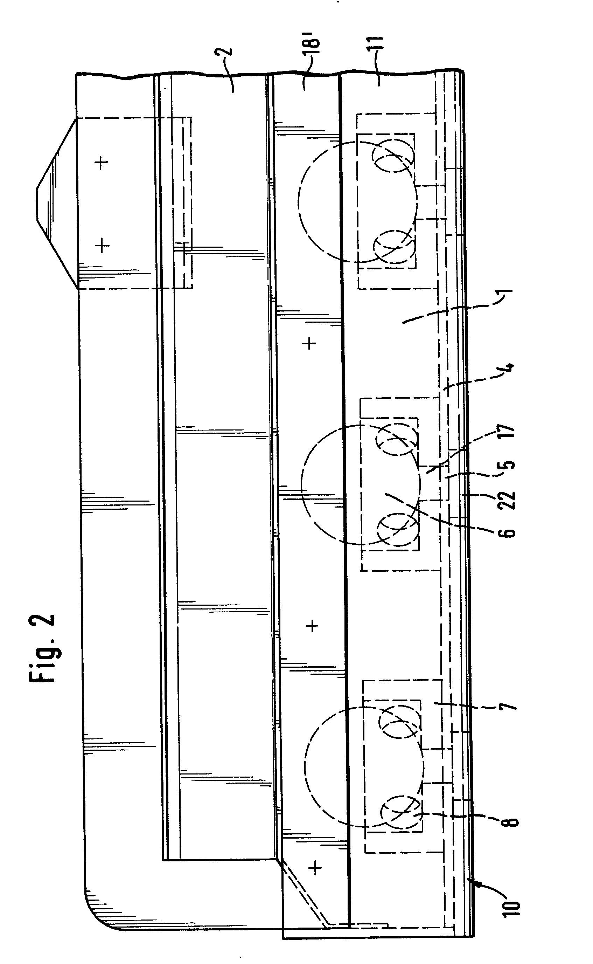

Wie aus der Fig. 2 ersichtlich ist, erstreckt sich der Vorratsbehälter 1 mit seinen Längsseiten quer zur Durchlaufrichtung A der Druckplatte 16 und weist zumindest drei Führungen 7 mit den zugehörigen Ventilkugeln 6 und Durchlässen 17 auf. Selbstverständlich können

HOECHST AKTIENGESELLSCHAFT
KALLE Niederlassung der Hoechst AG

- 7 -

auch mehr als drei Führungen in dem Vorratsbehälter 1 vorgesehen werden.

Der Ausreibeplüsch 13 ist als Plüschbalken ausgebildet, der sich gleichfalls quer zur Durchlaufrichtung A der Druckplatte 16 erstreckt.

Wenn die Oszillatoreinrichtung 15 der Antragsvorrichtung 10 eingeschaltet ist, werden sowohl der Ausreibeplüsch 13 als auch der Vorratsbehälter 1 und der auf seiner Außenseite befindliche Plüsch 11 quer zur Durchlaufrichtung A der Druckplatte 16 hin- und herbewegt. Durch diese oszillierende Bewegung geraten die über den Durchlässen 17 sitzenden Ventilkugeln 6 in den Führungen, da sie in diesen mit einem Spiel 9,9' gelagert sind, in eine durch das Lagerspiel begrenzte Schaukelbewegung und geben somit jeweils für eine gewisse Zeitspanne die Durchlässe 17 frei. Es kann dann durch diese Durchlässe 17 der in den Führungen 7 stehende Lack 3 auf die Plattenoberfläche fließen. Mit dem außen am Behälterboden 4 des Vorratsbehälters 1 angebrachten Plüsch 11 wird der Lack 3 gleichmäßig als Film über die gesamte Plattenbreite verteilt. Sobald die Druckplatte 16 mit dem Lackfilm auf der Oberfläche den oszillierenden Ausreibeplüsch 13 erreicht hat, wird sie entwickelt und gleichzeitig lackiert.

---

0026900

## Patentansprüche

1. Antragsvorrichtung für lackentwickelbare Druckplatten, mit einem Ausreibeplüsch, der mit einer Oszillatoreinrichtung verbunden ist, dadurch gekennzeichnet, daß an der Oszillatoreinrichtung (15) ein Vorratsbehälter (1) für Lack befestigt ist, der im Behälterboden (4) eine Anzahl von Antragsöffnungen (5) aufweist, die mit darüberliegenden Durchlässen (17) von Führungen (7) in Verbindung stehen, und daß in den Führungen (7) Ventilkugeln (6) angeordnet sind, die die Durchlässe (17) öffnen und schließen.

2. Antragsvorrichtung nach Anspruch 1, dadurch gekennzeichnet, daß der Vorratsbehälter (1) in Durchlaufrichtung A von Druckplatten (16) gesehen vor dem Ausreibeplüsch (13) an einem Befestigungswinkel (12) der Oszillatoreinrichtung (15) angebracht ist.

3. Antragsvorrichtung nach Anspruch 1, dadurch gekennzeichnet, daß über jeder Antragsöffnung (5) eine Führung (7) mit einer Ventilkugel (6) vorhanden ist und daß jede Ventilkugel (6) mit seitlichem Spiel (9,9') in der Führung gelagert ist.

4. Antragsvorrichtung nach Anspruch 3, dadurch gekennzeichnet, daß jede Führung (7) einen U-förmigen Querschnitt besitzt und zumindest eine Öffnung (8) aufweist, durch die Lack (3) aus dem Lackvorrat im Vorratsbehälter (1) zu dem Durchlaß (17) gelangt, wenn die

0026900

H O E C H S T   A K T I E N G E S E L L S C H A F T
KALLE   Niederlassung der Hoechst AG

- 9 -

Ventilkugel (6) während der Oszillatorbewegung den
Durchlaß (17) freigibt.

5. Antragsvorrichtung nach Anspruch 4, dadurch gekennzeichnet, daß jede Führung zwei Öffnungen (8) aufweist,
durch die Lack in das Innere der Führung (7) einströmt
und daß im Stillstand der Antragsvorrichtung (10) die
Ventilkugel (6) den Durchlaß (17) verschließt, so daß
sich Lack in der Führung (7) ansammelt.

6. Antragsvorrichtung nach den Ansprüchen 1 bis 5, dadurch gekennzeichnet, daß auf den Außenseiten und außen
am Behälterboden (4) des Vorratsbehälters (1) ein
Plüsch (11) angebracht ist, der mit der Lackschicht auf
der Druckplattenoberfläche in Berührung steht.

7. Antragsvorrichtung nach Anspruch 1, dadurch gekennzeichnet, daß sich der Vorratsbehälter (1) mit seinen
Längsseiten quer zur Durchlaufrichtung A der Druckplatten (16) erstreckt und daß zumindest drei Führungen (7)
mit den dazugehörigen Ventilkugeln (6) und Durchlässen
(17) vorhanden sind.

8. Antragsvorrichtung nach Anspruch 1, dadurch gekennzeichnet, daß der Ausreibeplüsch (13) als Plüschbalken
ausgebildet ist, der quer zur Durchlaufrichtung A der
Druckplatten (16) über ein Trägerblech (19), einen
Winkel (20) und einen Plüschträger (14) an einem Befestigungswinkel (12) der Oszillatoreinrichtung (15)
angebracht ist.

---

# Fig. 1

0026900

Fig. 2

Europäisches
Patentamt

**EUROPÄISCHER RECHERCHENBERICHT**

0026900
Nummer der Anmeldung

EP 80105888.4

| Kategorie | Kennzeichnung des Dokuments mit Angabe, soweit erforderlich, der maßgeblichen Teile | betrifft Anspruch |
|---|---|---|
| | **EINSCHLÄGIGE DOKUMENTE** | |
| | <u>CH - A - 547 698</u> (AMERICAN HOECHST CORPORATION) <br><br> + Fig. 1 + <br><br> -- | 1,8 |
| D | <u>US - A - 3 955 433</u> (HOVEKAMP) <br><br> -- | |
| D | <u>US - A - 3 983 758</u> (HOVEKAMP) <br><br> ---- | |

**KLASSIFIKATION DER ANMELDUNG (Int. Cl.³)**

G 03 D 5/06

**RECHERCHIERTE SACHGEBIETE (Int. Cl.³)**

G 03 D
G 03 G
G 03 F
F 16 H

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| WIEN | 16-12-1980 | KAHOVEC |

EPA form 1503.1   06.78